# EUROPEAN PATENT SPECIFICATION

(11) **EP 0 638 180 B1**
(45) Date of publication and mention of the grant of the patent: **13.02.2002**
(21) Application number: 93908877.9
(22) Date of filing: 01.04.1993
(51) Int. Cl.: G03F 7/20, G03F 7/00, B41M 5/24, H01L 31/00

(54) **PRODUCTION OF 2D-ARRAYS**
HERSTELLUNG VON 2D-ARRAYS
PRODUCTION DE RESEAUX BIDIMENSIONNELS

(30) Priority: 03.04.1992 IL 10148992
(43) Date of publication of application: 15.02.1995
(73) Proprietor: YISSUM RESEARCH DEVELOPMENT COMPANY OF THE HEBREW UNIVERSITY OF JERUSALEM, Jerusalem 91042 (IL); HADASIT MEDICAL RESEARCH SERVICES & DEVELOPMENT CO. LTD., Jerusalem 91120 (IL); RAPAPORT, Erich, Tel Aviv, 69 345 (IL)
(72) Inventor: Haronian, Dan, 90962 Efrat (IL); Lewis, Aaron, 93707 Jerusalem (IL)
(74) Representative: Weisert, Annekäte, Dipl.-Ing. Dr.-Ing.
(86) International application number: EP9300800
(87) International publication number: WO9320481

(56) References cited:
- EP-A- 0 489 972
- DE-A- 4 118 987
- GB-A- 2 196 143
- US-A- 4 824 488
- US-A- 4 896 049
- US-A- 4 943 710
- APPLIED PHYSICS LETTERS vol. 61, no. 18, 2 November 1992, NEW YORK US pages 2237 - 2239 , XP324697 HARONIAN ET AL. 'Microfabricating bacteriorhodopsin films for imaging and computing'
- PATENT ABSTRACTS OF JAPAN vol. 015, no. 507 (P-1291)20 December 1991
- PATENT ABSTRACTS OF JAPAN vol. 016, no. 053 (P-1309)12 February 1992

## Description

The invention relates to a method for the production of any array of pixels of heat-sensitive material, with one of a wide variety of properties, such as electro-optical, magneto-optical etc. properties, defining an orderly geometric pattern, said pixels being connected by a pattern of electrically conductive transparent or opaque strips allowing for the connection of one or more of the pixels with external means of recording at any desired instant. Furthermore, the invention relates to such an array.

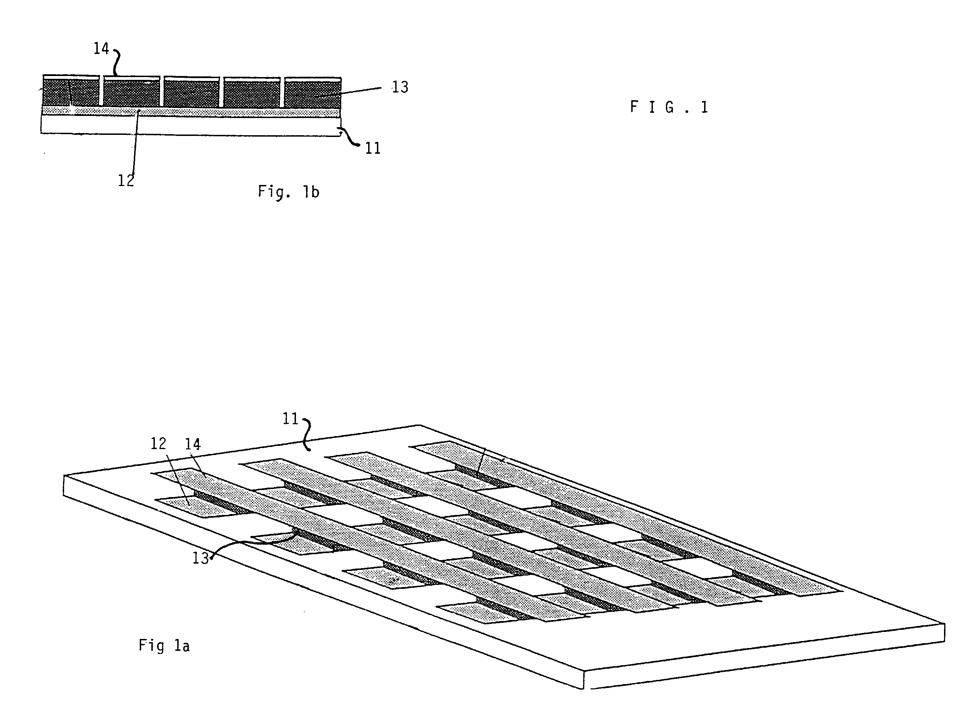

Recently there have been several reports concerning the use in electrooptics of a unique biological, polymeric and other materials. One example of such a material is the membrane called purple membrane which contains the protein called bacteriorhodopsin (bR). All of the applications of bR for producing devices demand a method that will be able to microfabricate this protein containing membrane without effecting the electooptical properties of bR. This is generally the case for many of the newly discovered materials that will be important in the future in electronic, optical and electrooptical device fabrication. Many of the most unique applications of such materials demand the generation of an array of electrodes sandwiched pixels (Figure 1). In the case of bR for example, since it is a protein, it is not possible to use the generally used techniques of microelectronics that microfabricate silicon by methodolgies such as reactive ion etching etc., without destroying the required properties of the protein. In addition, any methodology designed for micropatterning bR must be based on low temperature processes since the protein is sensitive to heat above 60 degrees C.

Conventional techniques used with the usual materials in microelectronics, such as in the production of printed circuits and semi-conductor chips are not applicable with heat-sensitive substance which would be deactivated or even decomposed by the drastic conditions of conventional techniques, which employ corrosive substances, high vacuum, etc. The novel process of the invention overcomes these drawbacks and provides for the production of mico-arrays of inter-connectable pixels down to very small dimensions, in the micron size range.

US-A-4 943 710 discloses an image sensor and a manufacturing method for the same wherein a structure of conductive transparent stripes connecting pixels sandwiched therebetween in two different directions is disclosed. However, the pixels in the known structure consist of a semiconductor material and not of a heat-sensitive material like a protein as according to the present invention which is sensitive to heat, particu-larly to a temperature above 60°C. Because the process of US-A-4 943 710 comprises steps requiring high temperature, this process would inactivate any protein or similarly sensitive material. Therefore, such a heat-sensitive material cannot be exposed to the condition to which the semiconductor material of US-A-4 943 710 is exposed during the manufacture of the structure.

JP-A-3 252 530, which discloses the depositing of films utilizing bacteriorhodospin, relates to a color image photodetector wherein the oriented films combined with the hapten lipid, an antibody having two kinds of antigen specificities (Bi specific antibody) and the photosensitive dyestuff protein are deposited on the electrodes, by which plural combinations >=2 kinds of photodetecting units (pixels) having a photoelectric converting function and different photosensitive wavelengths are provided to form photodetectors. However, due to the above discussion of US-A-4 943 710, a skilled person would not be directed by the teaching of US-A-4 943 710 to use the patterning steps disclosed in that document, for example in conjunction with a material disclosed by the aforementioned JP-A-3 252 530.

The present invention provides an array of pixels according to claim 1 and a process for the production of such an array according to claim 7.

In more detail, the invention relates to arrays of pixels of heat-sensitive materials, defining an orderly geometric pattern, provided with electrode patterns enabling the connection at any one period of time of one or more of the pixels with current detection means external to such array. The pixels can be produced in any desired size, down to dimensions as small as less than a micron. The pixels are interconnected by a pattern of conductor stripes, where the stripes facing a source of suitable electromagnetic radiation, such as light, are essentially transparent to such radiation. The invention further relates to a method for the production of such micro-arrays of pixels, which is characterised in that only such conditions are used which do not impair the activity of heat-sensitive substances, which are the main component of the said pixels.

In general terms, the process of the invention comprises applying to a suitable substrate, such as glass, a thin transparent layer of an electrically conductive material, to which there is applied a thin layer of the active material, and on top of which there is positioned a suitable mask defining a pattern of parallel stripes. The thus created array is irradiated by a suitable energy source, such as an excimer laser, so as to remove the exposed material through a mask in a specified pattern both at the layer of the electrooptical material as well as the conductive layer, down to the substrate. If required, the array is cooled especially during the removal of the conductive material, so as not to damage the sensitive substance.

After this patterning step the mask is removed and there is deposited on the entire area a thin film of conducting substance such as aluminum. This will be generally in the range of from about 10 µm to about 100 µm thick. On top of the thus produced electrically conductive layer, there is applied a mask, perpendicular to the direction of the first pattern of parallel stripes. The array is again irradiated, and this time the exposure is such as to remove, according to the pattern defined by the grid, the aluminium and the sensitive material, down to the first electrically conductive layer, which is left intact.

Thus there is created a pattern of geometrically arranged individual pixels, sandwiched between a pattern of criss-crossing electrically conductors, where the ones in a certain direction are beneath the pixels, and the others, perpendicular to the first ones, are on top and in contact with the said pixels. The array of conductive stripes makes possible to connect one or more desired pixels with the outside of the pixel-array, and to disconnect these as well.

The invention is illustrated with reference to the protein bacteriorhodopsin (bP) which is also termed "purple membrane", which is a well-known electrooptical active, yet heat-sensitive material.

The invention is illustrated by way of example with reference to the enclosed schematical Figures, which are not according to scale and in which:
Figure 1. A schematic of a pixel array of electrode sandwiching of an electrooptical material such as bacteriorhodopsin, essential for many computing and imaging electrooptical applications of new device materials such as bacteriorhodopsin.
Figure 2 A schematic representation of the micropatterning procedure described in the text and used to create a large array of active electrode sandwiched bR pixels.

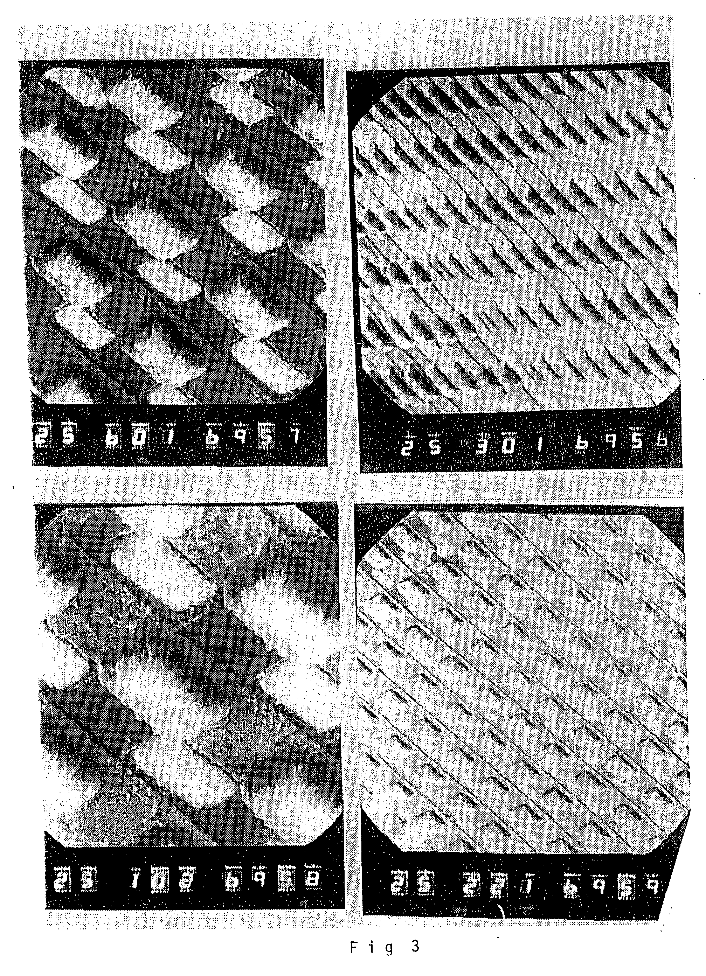

Figure 3. Scanning electron micrograph of active electrode sandwiched bR pixels. Each pixel is 30 µm x 30 µm.

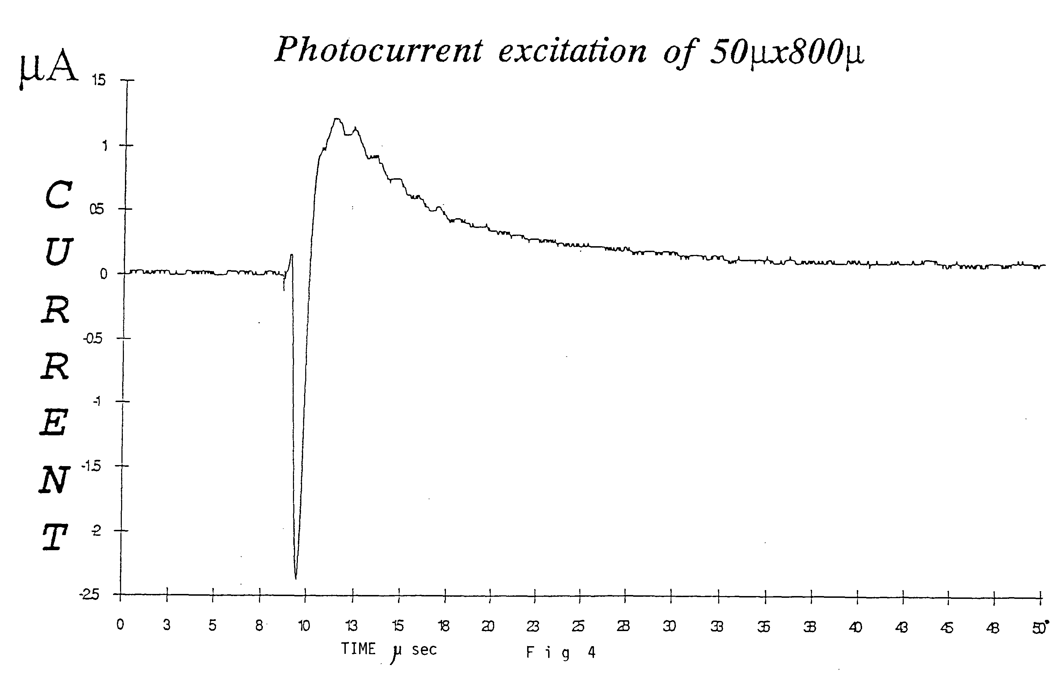

Figure 4. The photocurrent response of microfabricated bR bar of 50 µm x 800 µm. This response is identical to that which is obtained from bR films that have not been exposed to the microfabrication process.

As shown in Fig. 1 an array according to the present invention comprises a substrate 11, such as glass, on which there is deposited a pattern of parallel stripes 12 of transparent electrically conductive material, which support a pattern of pixels 13 of an electroactive or other substance, the area of which corresponds to the width of the stripes 12, below the pixels, and of the stripes 14, perpendicular to the direction of stripes 12 which are positioned on the pixels 13. Fig. 1a is a perspective view of the array and Fig. 1b is a sectional side view of this pattern.

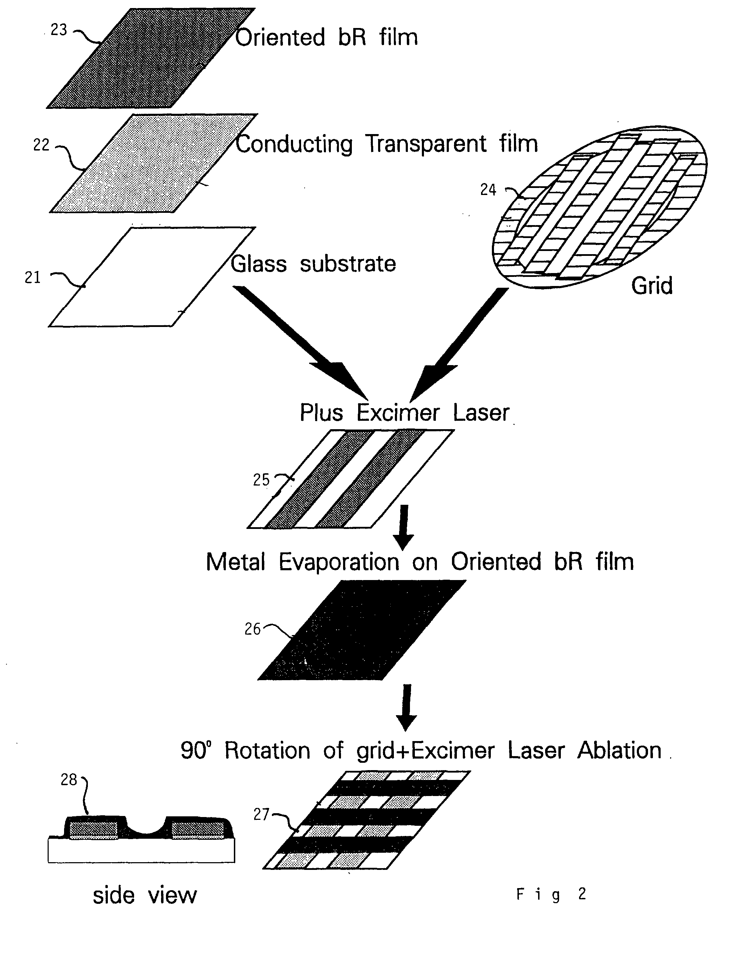

As shown in the exploded view of Fig. 2, the materials used are a glass substrate 21, a conducting transparent or translucent film 22 and an oriented film of the active substance, in this case bR, 23 and grid 24. There is used an excimer laser for obtaining the stripe pattern 25, and after this there is evaporated on top a metal film 26, and after rotation of the mask (grid) 24 by 90 degrees, and laser ablation, there is obtained the pattern shown in 27, with 28 being a sectional side view of the finished pattern.

The invention is further described with reference to the following example, which illustrates the production of micronrange size pixels in a structure according to the invention. As substrate there was chosen a glass plate of 5mm by 5mm of 1mm thickness. On this there was applied a transparent layer of tin oxide of uniform thickness of 500Å. On top of this layer there was applied a suspension of bacteriorhodopsin (bR) of 100 µl with O.D. 15.
This was dried by an electric field.
A microscope grid (of an electron microscope) with a bar thickness of 30 µm and with a distance of 30 µm between bars was applied on top of this layer, and the bR between the bars was ablated using an Argon fluoride Excimer laser of mJ per pulse energy, using a beam size of 2 x 4 mm.
About 40 pulses of 10 µsec duration each were required to remove the bR layer between the bars and after this pulses of the same laser with the same power and pulse time to ablate also the tin oxide layer between the bars. During this process step the glass bar was cooled down to about 10 degrees C.
After removal of the grid there was applied an aluminium layer of about 100Å thickness on the entire surface of the glass substrate by conventional vapour deposition. The grid was again placed on the substrate, this time on top of the aluminium layer, with the bars perpendicular to the first direction. 40 pulses of the same excimer laser with the same power and pulse duration was used to ablate the aluminium layer and the bR layer, without damaging the tin oxide layer beneath these two. A pattern bR dB pixels of about 30 x 30 µm was obtained, with strip-shaped transparent electrodes connecting these in one direction beneath the bR layer, and in a perpendicular to this on top of the bR layer.

## Claims

1. An array of pixels (13) of submicron size up to the size of some tens of microns, made of the heat-sensitive material bacteriorhodopsin (bR) which is sensitive to heat at a temperature above 60°C and which deteriorates and loses its required electroactive, electrooptical, magnetooptical and other similar properties when subjected to such heat and other conditions which cause deterioration of the heat-sensitive material, which pixels (13) are sandwiched and interconnected in different directions by a corresponding pattern of electrically conductive stripes (12, 14) wherein at least one pattern of said conductive stripes (12, 14) is transparent to the energy necessary to excite the active material and which stripes (12, 14) are in one direction in contact with the lower surface of the pixels (13), and in another direction in contact with the upper surface of the pixels (13), said stripes (12, 14) being connectable to exterior recording or detecting means.

2. An array according to claim 1 where at least one array (12) of parallel conductive stripes (12) is transparent to the energy necessary to excite the active material and deposited on a similarly transparent insulating substrate (11), the pixels (13) of heat-sensitive material are above and in contact with these stripes (12), there being provided a second array of parallel conductive stripes (14) perpendicular with the first array, above and in contact with said pixels (13).

3. An array according to claim 1 or 2, where the pixels (13) are in the micron or submicron size range.

4. An array according to any of claims 1 to 3, where the pixels (13) consist of or contain bacteriorhodopsin (bR) as heat-sensitive material.

5. An array according to any of claims 1 to 4, where the first array of parallel stripes (12) consists of thin stripes (12) of tin oxide on a glass substrate (11), and the second array of stripes (14), above the heat-sensitive material, is a stripe pattern of vacuum deposited and patterned metal.

6. An array according to claim 4 or 5, where the heat-sensitive material is an oriented bR film (23).

7. A process for the production of an array of pixels (13) according to claim 1 comprising:
(a) applying to an insulating substrate (21), transparent to the energy necessary for exciting the active material, a similarly transparent electrically conductive film (22);
(b) applying on top of said electrically conductive film (22) a layer of the heat-sensitive material (23) ;
(c) positioning on top of this layer (23) of heat-sensitive material a mask (24) defining a pattern (25) of parallel stripes;
(d) removing the exposed material of the layer (23) of the heat-sensitive material bacteriorhodopsin (bR) (29) by a suitable beam of adequate energy;
(e) removing in a similar manner corresponding regions of the conductive material (22);
(f) applying by vapor deposition a thin metal layer (28) on the entire surface;
(g) positioning on this metal layer a mask (24) at some angle oriented relative to the first mask direction;
(h) removing the top metal layer (28) according to the pattern of the mask (24), resulting in said pixels (13) of the heat-sensitive substance arranged between conductive stripes (12, 14); and
(i) providing means to connect each of the pixels (13) with external recording or detecting means.

8. A process according to claim 7, which comprises producing an array of pixels (13) or a material sensitive to heat and other factors adversely affecting sensitive material, sandwiched between conductive transparent electrodes in the form of stripes (12, 14) where the electrode below the pixel (13) extends in one direction, and that above the pixel (13) extends at an angle of 90° with the lower electrode.

9. A process according to claim 7 or 8, where the heat-sensitive material is a protein, polymer, compound or complex.

10. A process according to claim 7, 8 or 9, where the conductive layer (22) is applied to a glass substrate (21), where the metal layer (28) is applied by vapor deposition, and where the removal steps are effected by a sufficiently deep ultraviolet laser of mJ power with a plurality of pulses.

11. A process according to claims 7, 8, 9 or 10, where the conductive layer is one of tin oxide of some hundreds of Å thickness, where the masks define pixels (13) down to dimensions as small as less than a micron, and where the metal layer (28) is one of aluminium, of a thickness in the 100 Å range.

## Patentansprüche

1. Anordnung von Bildpunkten (13) in Submikrongröße bis zu einer Größe von einigen zehn Mikrometern, welche aus dem wärmeempfindlichen Material Bakteriorhodopsin (bR) gefertigt ist, welches bei einer Temperatur über 60°C wärmeempfindlich ist und seine erforderlichen elektroaktiven, elektrooptischen, magnetooptischen und andere ähnliche Eigenschaften verschlechtert und verliert, wenn es einer derartigen Wärme oder anderen Bedingungen, die eine Verschlechterung des wärmeempfindlichen Materials hervorrufen, ausgesetzt wird, wobei die Bildpunkte (13) sandwichartig zwischen einem entsprechenden Muster von elektrisch leitfähigen Streifen (12, 14) angeordnet und dadurch in unterschiedlichen Richtungen miteinander verbunden sind, wobei mindestens ein Muster der leitfähigen Streifen (12, 14) bezüglich der zur Anregung des aktiven Materials notwendigen Energie durchlässig ist, wobei diese Streifen (12, 14) in einer Richtung in Kontakt mit der unteren Fläche der Bildpunkte (13) und in einer anderen Richtung in Kontakt mit der oberen Fläche der Bildpunkte (13) stehen, wobei die Streifen (12, 14) an externe Aufzeichnungs- oder Erfassungsmittel anschließbar sind.

2. Anordnung nach Anspruch 1, wobei mindestens eine Anordnung (12) von parallelen leitfähigen Streifen (12) bezüglich der zur Anregung des aktiven Materials notwendigen Energie durchlässig und auf einem ähnlich durchlässigen Isoliersubstrat (11) abgelagert ist, wobei die Bildpunkte (13) aus dem wärmeempfindlichen Material oberhalb dieser Streifen (12) angeordnet sind und mit diesen Streifen in Kontakt stehen, wobei oberhalb der Bildpunkte (13) und damit in Kontakt eine zu der ersten Anordnung senkrechte zweite Anordnung von parallelen leitfähigen Streifen (14) vorgesehen ist.

3. Anordnung nach Anspruch 1 oder 2, wobei die Bildpunkte (13) eine Größe im Mikron- oder Submikronbereich besitzen.

4. Anordnung nach einem der Ansprüche 1 bis 3, wobei die Bildpunkte (13) aus Bakteriorhodopsin (bR) als wärmeempfindliches Material bestehen oder dieses beinhalten.

5. Anordnung nach einem der Ansprüche 1 bis 4, wobei die erste Anordnung von parallelen Streifen (12) aus dünnen Streifen (12) aus Zinnoxid auf einem Glassubstrat (11) besteht, und wobei die oberhalb des wärmeempfindlichen Materials befindliche zweite Anordnung von Streifen (14) ein Streifenmuster aus einem im Vakuum abgelagerten und gemusterten Metall ist.

6. Anordnung nach Anspruch 4 oder 5, wobei das wärmeempfindliche Material ein ausgerichteter bR-Film (23) ist.

7. Verfahren zur Herstellung einer Anordnung von Bildpunkten (13) nach Anspruch 1, umfassend:
(a) Aufbringen auf ein Isoliersubstrat (21), welches bezüglich der zur Anregung des aktiven Materials notwendigen Energie durchlässig ist, einen ähnlich durchlässigen elektrisch leitfähigen Film (22),
(b) Aufbringen einer Schicht aus dem wärmeempfindlichen Material (23) auf die Oberseite des elektrisch leitfähigen Films (22),
(c) Anordnen einer ein Muster (25) aus parallelen Streifen definierenden Maske (24) auf der Oberseite dieser Schicht (23) aus dem wärmeempfindlichen Material,
(d) Entfernen des freigelegten Materials der Schicht (23) aus dem wärmeempfindlichen Material Bakteriorhodopsin (bR) (29) mit Hilfe eines geeigneten Strahls angemessener Energie,
(e) Entfernen entsprechender Bereiche des leitfähigen Materials (22) auf ähnliche Weise,
(f) Aufdampfen einer dünnen Metallschicht (28) auf die gesamte Oberfläche,
(g) Anordnen einer Maske (24), welche mit einem bestimmten Winkel relativ zu der Ausrichtung der ersten Maske ausgerichtet ist, auf dieser Metallschicht,
(h) Entfernen der oberen Metallschicht (28) gemäß dem Muster der Maske (24), was zur Folge hat, dass die Bildpunkte (13) aus der wärmeempfindlichen Substanz zwischen leitfähigen Streifen (12, 14) angeordnet sind, und
(i) Bereitstellen von Mitteln, um jeden Bildpunkt (13) mit externen Aufzeichnungs- oder Erfassungsmitteln zu verbinden.

8. Verfahren nach Anspruch 7, welches die Herstellung einer Anordnung von Bildpunkten (13) oder eines wärmeempfindlichen oder gegenüber anderen beeinträchtigenden Faktoren empfindlichen Materials sandwichartig zwischen leitfähigen durchlässigen Elektroden in Form von Streifen (12, 14), wobei die Elektrode unterhalb der Bildpunkte (13) in eine Richtung und die Elektrode oberhalb der Bildpunkte (13) unter einem Winkel von 90° zu der unteren Elektrode verläuft.

9. Verfahren nach Anspruch 7 oder 8, wobei das wärmeempfindliche Material ein Protein, ein Polymer, eine Verbindung oder ein Komplex ist.

10. Verfahren nach Anspruch 7, 8 oder 9, wobei die leitfähige Schicht (22) auf ein Glassubstrat (21) aufgetragen wird, wobei die Metallschicht (28) durch Aufdampfen aufgetragen wird, und wobei die Entfernungsschritte durch einen ausreichend dunklen ultravioletten Laser mit mJ-Leistung und einer Vielzahl von Impulsen durchgeführt wird.

11. Verfahren nach Anspruch 7, 8, 9 oder 10, wobei die leitfähige schicht eine Zinnoxidschicht mit einer Dicke von einigen hundert Å ist, wobei die Masken Bildpunkte (13) mit Abmessungen bis zu kleiner als einen Mikrometer definieren, und wobei die Metallschicht (28) eine Aluminiumschicht mit einer Dicke im Bereich von 100 Å ist.

## Revendications

1. Ensemble de pixels (13) dont la taille varie de la taille du sous-micron à la taille de quelques dizaines de microns, constitué du matériau thermosensible bactériorhodopsine (bR) qui est sensible à la chaleur à une température supérieure à 50°C et qui détériore et perd ses propriétés électroactive, électrooptique, magnétooptique et d'autres propriétés similaires lorsqu'il est soumis à une telle chaleur et à d'autres conditions qui provoquent la détérioration du matériau thermosensible, lesdits pixels (13) étant pris en sandwich et interconnectés dans différentes directions par un modèle correspondant de bandes électriquement conductrices (12, 14) dans lequel au moins un modèle desdites bandes conductrices (12, 14) est transparent à l'énergie nécessaire à l'excitation du matériau actif et lesdites bandes (12, 14) étant dans une direction en contact avec la surface inférieure des pixels (13), et dans une autre direction en contact avec la surface supérieure des pixels (13), lesdites bandes (12, 14) pouvant être connectées avec des moyens de détection ou d'enregistrement extérieurs.

2. Ensemble selon la revendication 1, dans lequel au moins un ensemble (12) de bandes conductrices parallèles (12) est transparent à l'énergie nécessaire à l'excitation du matériau actif déposé sur un substrat isolant également transparent (11), les pixels (13) en matériau thermosensible étant situés au-dessus et étant en contact avec ces bandes (12), un second ensemble de bandes conductrices parallèles (14) étant prévu perpendiculairement au premier ensemble, au-dessus et en contact avec lesdits pixels (13).

3. Ensemble selon la revendication 1 ou la revendication 2, dans lequel les pixels (13) sont compris dans la plage de tailles allant de la taille du micron à la taille du sous-micron.

4. Ensemble selon l'une quelconque des revendications 1 à 3, dans lequel les pixels (13) sont constitués de ou contiennent la bactériorhodopsine (bR) en tant que matériau thermosensible.

5. Ensemble selon l'une quelconque des revendications 1 à 4, dans lequel le premier ensemble de bandes parallèles (12) est constitué de bandes minces (12) d'oxyde d'étain sur un substrat de verre (11), et dans lequel le second ensemble de bandes (14), situé au-dessus du matériau thermosensible, est un modèle de bande de métal modelé et déposé sous vide.

6. Ensemble selon la revendication 4 ou la revendication 5, dans lequel le matériau thermosensible est un film bR orienté (23).

7. Procédé pour la production d'un ensemble de pixels (13) selon la revendicatian 1, comprenant les étapes consistant à :
a) appliquer sur un substrat isolant (21), transparent à l'énergie nécessaire à l'excitation du matériau actif, un film électriquement conducteur également transparent (22) ;
b) appliquer au-dessus dudit film électriquement conducteur (22) une couche du matériau thermosensible (23) ;
c) positionner au-dessus de cette couche (23) de matériau thermosensible un masque (24) définissant un modèle (25) de bandes parallèles ;
d) enlever le matériau exposé de la couche (23) du matériau thermosensible bactériorhodopsine (bR) (29) par un faisceau adapté d'énergie adéquate ;
e) enlever de manière similaire des régions correspondantes du matériau conducteur (22) ;
f) appliquer par la technique de dépôt en phase vapeur une mince couche de métal (28) sur la totalité de la surface ;
g) positionner sur cette couche de métal un masque (24) selon un certain angle orienté par rapport à la première direction du masque ;
h) enlever la couche de métal du desaus (28) selon le modèle du masque (24), résultant en lesdits pixels (13) de la substance thermosensible disposée entre les bandes conductrices (12, 14) ; et
i) fournir des moyens pour connecter chacun des pixels (13) avec des moyens de détection ou d'enregistrement extérieurs.

8. Procédé selon la revendication 7, comprenant l'étape consistant à produire un ensemble de pixels (13) ou un matériau sensible à la chaleur et à d'autres facteurs qui affectent de manière défavorable le matériau sensible, pris en sandwich entre des électrodes transparentes conductrices sous la forme de bandes (12, 14), dans lesquelles l'électrode située en dessous du pixel (13) s'étend dans une direction, et celle située au-dessus du pixel (13) s'étend selon un angle de 90° par rapport à l'électrode inférieure.

9. Procédé selon la revendication 7 ou la revendication 8, dans lequel le matériau thermosensible est une protéine, un polymère, un composé ou un complexe.

10. Procédé selon la revendication 7, 8 ou 9, dans lequel la couche conductrice (22) est appliquée sur un substrat de verre (21), dans lequel la couche de métal (28) est appliquée par la technique de dépôt en phase vapeur, et dans lequel les étapes de retrait sont effectuées par un laser ultraviolet à longueur d'onde suffisamment courte de puissance mJ avec un pluralité d'impulsions.

11. Procédé selon la revendication 7, 8, 9 ou 10, dans lequel la couche conductrice est une couche d'oxyde d'étain de quelques centaines d'Å d'épaisseur, dans lequel les masques définissent des pixels (13) jusqu'à des dimensions aussi petites que le sous-micron, et dans lequel couche de métal (28) est une couche d'aluminium, d'une épaisseur de l'ordre d'une centaine d'Å.
